## Europäisches Patentamt

## European Patent Office

## Office européen des brevets

(11) Veröffentlichungsnummer: **0 193 655**
**B1**

(12) **EUROPÄISCHE PATENTSCHRIFT**

(45) Veröffentlichungstag der Patentschrift:
16.08.89

(51) Int. Cl.⁴: **H 03 C 1/60**

(21) Anmeldenummer: 85116487.1

(22) Anmeldetag: 23.12.85

(54) Einseitenbandmodulationsverfahren, Einseitenbandmodulator und Rundfunksender.

(30) Priorität: 14.02.85 CH 671/85

(43) Veröffentlichungstag der Anmeldung:
10.09.86 Patentblatt 86/37

(45) Bekanntmachung des Hinweises auf die Patenterteilung:
16.08.89 Patentblatt 89/33

(84) Benannte Vertragsstaaten:
CH DE FR GB LI NL

(56) Entgegenhaltungen:
EP-A- 0 112 410
US-A- 2 988 711

BROWN, BOVERI REVIEW, Band 72, Nr. 7, Juli 1985,
Seiten 332-335, Baden, CH; M. GAUTSCHI et al.: "A new
method of single-sideband modulation for high-power
broadcasting transmitters"
GEC JOURNAL OF SCIENCE & TECHNOLOGY, Band 39,
Nr. 2, 1972, Seiten 61-69, Wenbley, Middlesex, GB; W.
SARAGA: "Frequency-selective networks suitable for
microelectronic realization-2"

(73) Patentinhaber: BBC Brown Boveri AG, Haselstrasse,
CH-5401 Baden (CH)

(72) Erfinder: Gautschi, Max, Dr., Neunbrunnenstrasse 249,
CH-8046 Zürich (CH)

## Beschreibung

Bei der Erfindung wird ausgegangen von einem Einseitenbandmodulationsverfahren nach dem Oberbegriff des Patentanspruchs 1: Die Erfindung betrifft auch einen Einseitenbandmodulator und einen Rundfunksender mit einem Einseitenbandmodulator.

Mit dem Oberbegriff nimmt die Erfindung auf einen Stand der Technik Bezug, wie er in dem deutschen Buch: H. Meinke und F. W. Gundlach, Taschenbuch der Hochfrequenztechnik, Springer-Verlag, Berlin / Heidelberg / New York 1968, S. 1323–1325, beschrieben ist. Dort ist ein Einseitenbandmodulator für grossen Frequenzbereich der Trägerschwingung und breites Niederfrequenzband, nach Lenehan, dargestellt und beschrieben, bei dem für beide Frequenzbereiche Phasenteiler vorgesehen sind, die um 90° phasenverschobene Komponentensignale erzeugen. Diese Komponentensignale speisen zwei Ringmodulatoren, welche ihrerseits drei Endverstärkerröhren ansteuern. Nachteilig dabei ist, daß drei Röhren benötigt werden, die in ihrem linearen Bereich, d. h. in A- oder B-Betrieb betrieben werden müssen.

Ein Einseitenbandmodulator wird auch in der US-A-2988711 beschrieben. Dort werden jeweils Quadratursignale des Modulations- und Trägersignals in geeigneter Weise kombiniert, nämlich jeweils summiert und quadriert, sodann werden die Summensignale zu einem Einseitenbandsignal aufsummiert.

Die Erfindung, wie sie in den Patentansprüchen 1, 6, 10 und 11 definiert ist, löst die Aufgabe, ein Einseitenbandmodulationsverfahren, einen Einseitenbandmodulator und einen Rundfunksender mit Einseitenbandmodulation anzugeben, mit denen es möglich ist, einen Einseitenbandsender hoher Leistung mit nur einer Senderöhre zu betreiben.

Ein Vorteil der Erfindung liegt darin, daß die Senderöhre nicht in ihrem linearen Bereich betrieben werden muß, sondern bei beliebiger Aussteuerung im C-Betrieb mit einem höheren Anodenwirkungsgrad betrieben werden kann. Ein weiterer Vorteil besteht darin, daß sich Rundfunksender mit Amplitudenmodulation bei Bedarf unter Verwendung des erfindungsgemäßen Einseitenbandmodulators leicht nachrüsten und auf Einseitenbandtechnik umstellen lassen.

Unter Verwendung eines Modulations-Schaltverstärkers mit Puls-Stufenmodulation kann bei einem Rundfunksender ein hoher Modulatorwirkungsgrad und auch ein verbesserter Gesamtwirkungsgrad bei Einseitenbandmodulation erreicht werden. Da der Modulations-Schaltverstärker weitaus geringere Verluste aufweist als eine vergleichbare Modulationsröhre, resultiert ein hoher Gesamtwirkungsgrad des Senders. Der erhöhte Schaltungsaufwand für den Modulations-Schaltverstärker wird durch den geringeren Stromverbrauch rasch amortisiert. Der Modulations-Schaltverstärker hat einen geringen Platzbedarf und niedrige Betriebskosten, da keine Röhrenersatzkosten anfallen.

Bei einem Rundfunksender gewährleistet die geringe Zahl von Leistungskomponenten und Verschleißteilen neben einem hohen Wirkungsgrad eine hohe Verfügbarkeit, geringe Wartungskosten und ausgezeichnete Wartungsfreundlichkeit.

Gemäß einer vorteilhaften Ausgestaltung der Erfindung ist es möglich, das Einseitenbandsignal auch zusammen mit einem Trägersignal auszusenden.

Zum einschlägigen Stand der Technik wird zusätzlich auf die Schweizer Firmenzeitschrift Brown Boveri Mitteilungen 5, 1984, S. 202–205 verwiesen, aus der es für einen 600-kW-Mittelwellensender bekannt ist, mit nur einer HF-(Hochfrequenz-)-Hochleistungstetrode in der Endstufe und mit einem volltransistorisierten Modulations-Schaltverstärker mit Puls-Stufenmodulation bei Zweiseitenbandtechnik einen hohen Modulatorwirkungsgrad und auch einen hohen Gesamtwirkungsgrad des Senders zu erreichen. Dort wird das für die Amplitudenmodulation notwendige Produkt aus NF-(Niederfrequenz-)Signal und Hochfrequenzträger direkt in der HF-Endstufe gebildet. Dabei wird der Hochfrequenzträger mit konstanter Amplitude auf das Gitter der HF-Endstufe gegeben. Das aufzumodulierende NF-Signal steuert einen sogenannten Pulser, d. h. den Modulations-Schaltverstärker mit Pulsstufenmodulation bzw. einen der Sendeleistung entsprechend grossen Digital-Analog-Wandler, der die Anodenspannung entsprechend der momentanen Sendeleistung erzeugt.

Die Erfindung wird nachstehend anhand von Ausführungsbeispielen erläutert. Es zeigen:

Fig. 1 einen Einseitenbandmodulator,

Fig. 2 ein vereinfachtes Prinzipschema eines Rundfunksenders mit einem Einseitenbandmodulator gemäß Fig. 1 in digitaler Version und

Fig. 3 ein vereinfachtes Prinzipschema eines Rundfunksenders mit einem Einseitenbandmodulator gemäß Fig. 1 in analoger Version.

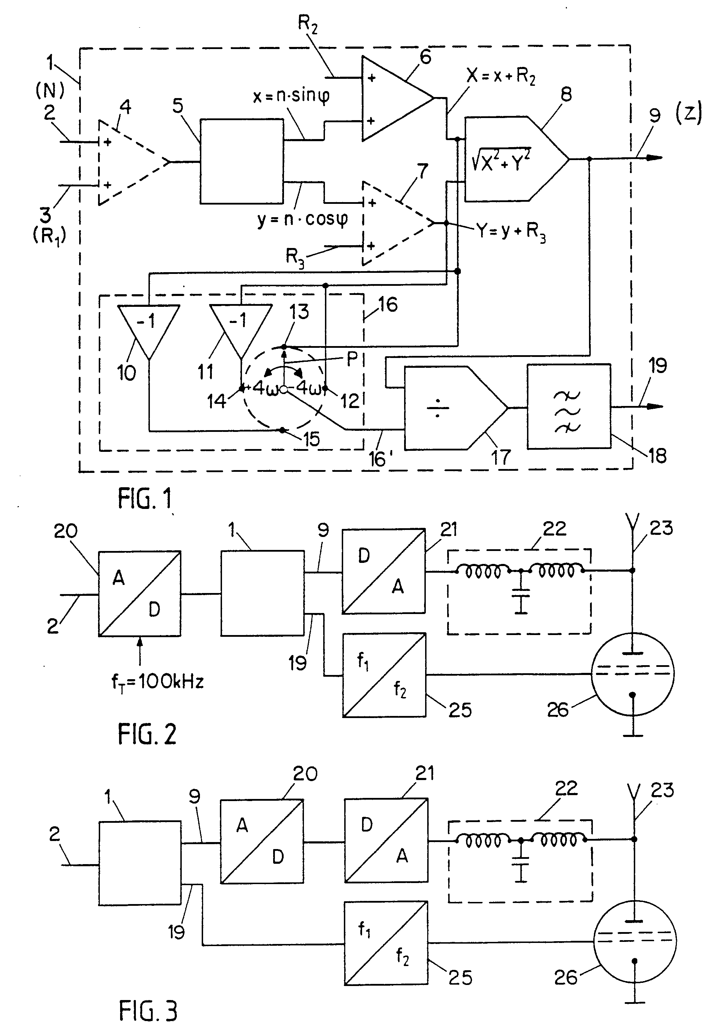

In Fig. 1 bezeichnet 1 einen Einseitenbandmodulator, 2 einen ersten Eingang für ein moduliertes NF-Signal bzw. ein Eingangssignal N(t), das von der Zeit t abhängig ist, und 4 ein Addierglied, dem über einen zweiten Eingang 3 ein Restträgersignal $R_1$ zugeführt ist.

Ausgangsseitig ist das Addierglied 4 mit dem Eingang eines Phasentrenners bzw. Hilberttransformators 5 verbunden, der ein Eingangssignal in mehrere Komponentensignale aufspaltet, die eine feste Phasenbeziehung zueinander haben. Im dargestellten Beispiel wird das Eingangssignal N der Übersichtlichkeit halber ohne Restträgersignal $R_1$ in zwei um 90° phasenverschobene Komponentensignale $x(t) = n(t) \cdot \sin \varphi(t)$ und $y(t) = n(t) \cdot \cos \varphi(t)$ aufgespaltet, deren Summe dem ursprünglichen Signal N(t) entspricht. Dabei ist n(t) der Scheitelwert und $\varphi(t)$ der Phasenwinkel von x(t). Hilberttransformatoren sind bekannt aus: Electronic Design 19, September 13, 1976, S. 90–94 und aus AEÜ (Archiv für Elektronik und Übertragungstechnik) 36 (1982) H. 7/8, S. 304–310.

Das Komponentensignal x ist einem Addiereingang eines Addiergliedes 6 und das Komponentensignal y einem Addiereingang eines weiteren Addiergliedes 7 zugeführt. Einem zweiten Addiereingang des Addiergliedes 6 ist ein Restträgersignal $R_2$ und einem zweiten Addiereingang des Addiergliedes 7 ein Restträgersignal $R_3$ zugeführt.

Die Restträgersignale $R_1$, $R_2$, $R_3$ sind konstant. Wenn das Restträgersignal $R_1$ mittels des Addiergliedes 4 dem NF-Eingangssignal N(t) zugeführt wird, dann erübrigen sich die Addierglieder 6 und 7. Andererseits genügt es, wenn ein Restträgersignal $R_2$ nur einem Komponentensignal, z. B. x, mittels des Addiergliedes 6 zugefügt wird; dann können die Addierglieder 4 und gegebenenfalls auch 7 entfallen.

Das Addierglied 6 liefert eingangsseitig ein Summensignal $X(t) = x(t) + R_2$, das einem ersten Eingang eines Amplitudenrechners 8 zugeführt ist. Das Addierglied 7 liefert ausgangsseitig ein Summensignal $Y(t) = y(t) + R_3$, das einem zweiten Eingang des Amplitudenrechners 8 zugeführt ist. Im Amplitudenrechner 8 werden die Eingangssignale X(t) und Y(t) quadriert, die Quadrate addiert und aus der Quadratsumme die Wurzel gezogen, so daß an einem Ausgang 9 des Amplitudenrechners 8 und gleichzeitig an einem Ausgang des Einseitenbandmodulators 1 ein Modulator-Amplitudensignal $Z(t) = \sqrt{X^2(t) + Y^2(t)}$ zur Verfügung steht, das keinen Phasenanteil aufweist.

Das Summensignal X ist ferner einerseits direkt mit einem Schaltkontakt 13 eines zyklischen Schalters 16 und andererseits über einen Inverter 10 mit einem Schaltkontakt 15 des zyklischen Schalters 16 verbunden, der bezüglich des Schaltkontaktes 13 um 180° versetzt ist.

Das Summensignal Y ist ferner einerseits direkt mit einem Schaltkontakt 12 des zyklischen Schalters 16 und andererseits über einen Inverter 11 mit einem Schaltkontakt 14 des zyklischen Schalters 16 verbunden, der bezüglich des Schaltkontaktes 12 um 180° versetzt ist, wobei der Schaltkontakt 12 gegenüber dem Schaltkontakt 13 um 90° versetzt ist.

Die durch einen Pfeil P angedeutete Schaltverbindung des Schaltkontaktes 13 mit einem Ausgang 16' des zyklischen Schalters 16 rotiert bei Verwendung des unteren Seitenbandes im Uhrzeigersinn, d. h., der Ausgang 16' wird nacheinander mit den Schaltkontakten 12, 15, 14, 13, 12 usw. verbunden. Bei Verwendung des oberen Seitenbandes rotiert die Schaltverbindung entgegen dem Uhrzeigersinn nacheinander über die Schaltkontakte 14, 15, 12 usw. Die Rotationsfrequenz ist gleich einer Taktfrequenz $f_T$ von 100 kHz, entsprechend der 4fachen Kreisfrequenz des Trägersignals mit einer Trägerfrequenz $f_1$ von 25 kHz. Der zyklische Schalter 16 ist ein elektronischer Schalter ohne rotierende Teile. Mit dieser Rotationsfrequenz erhält man am Ausgang 16', unter Voraussetzung, daß kein Restträgersignal $R_1$ oder $R_2$ oder $R_3$ zugefügt wurde, ein Abtastsignal $n(t_i) \cdot \cos(\omega t_i \pm \varphi(t_i))$, wobei das «+»-Zeichen für das obere und das «−»-Zeichen für das untere Seitenband gilt.

Unter der Annahme: $R_1 = 0$, $R_2 = 0$, $R_3 = 0$ gilt für das obere Seitenband und die Schaltkontakte 12....14:

12: $n(t_1) \cdot \cos\varphi(t_1) + 0 = n(t_1) \cdot \cos\varphi(t_1) + R_2 \cdot \sin(\omega t_1)$,
13: $n(t_2) \cdot \sin\varphi(t_2) + R_2 = n(t_2) \cdot \sin\varphi(t_2) + R_2 \cdot \sin(\omega t_2)$,
14: $-n(t_3) \cdot \cos\varphi(t_3) + 0 = -n(t_3) \cdot \cos\varphi(t_3) + R_2 \cdot \sin(\omega t_3)$,
15: $-n(t_4) \cdot \sin\varphi(t_4) - R_2 = -n(t_4) \cdot \sin\varphi(t_4) + R_2 \cdot \sin(\omega t_4)$
$= n(t_i) \cdot \cos(\omega t_i + \varphi(t_i)) + R_2 \cdot \sin(\omega t_i)$.

Die obigen Gleichungen sind leicht ersichtlich, wenn man für $\omega t_i$ nacheinander die Werte 0, $\pi/2$, $\pi$ und $3\pi/2$ einsetzt.

Das Abtastsignal am Ausgang des zyklischen Schalters 16 wird einem Quotientenbildner bzw. Dividierer 17 als Dividend zugeführt, und das Modulator-Amplitudensignal Z(t) vom Ausgang des Amplitudenrechners 8 als Divisor. Am Ausgang des Dividierers 17 erhält man ein Quotientensignal, das nur phasen- und nicht amplitudenabhängig $= \cos(\omega t_i \pm \varphi(t_i))$ ist.

Das durch den zyklischen Schalter 16 zeitdiskret vorhandene Ausgangssignal des Dividierers 17 wird einem Bandpaßfilter 18 zugeführt, an dem ausgangsseitig ein kontinuierliches Modulator-Phasensignal 19 zur Verfügung steht, wobei unerwünschte Nebenschwingungen durch das Bandpaßfilter 18 ausgefiltert werden. Das Bandpaßfilter 18 ist für 75 kHz ausgelegt, d. h. bezüglich 50 kHz (= Nyquistfrequenz zur Trägersignalfrequenz von 25 kHz) gespiegelt.

Wichtig ist, daß der Einseitenbandmodulator aus einem Niederfrequenzsignal ein momentanes Hochfrequenzphasensignal und einen momentanen Amplitudenwert bildet, derart, daß das Produkt dieser beiden Signale ein einseitenbandmoduliertes Signal ergibt. Die Produktbildung wird in der Hochfrequenz-Endstufe vorgenommen, wobei alle aus der Amplitudenmodulation bekannten Verfahren anwendbar sind (Anodenmodulation, Gittermodulation, Kathodenbasisschaltung, Gitterbasisschaltung). Der Modulator kann in analoger oder digitaler Technik aufgebaut werden. Auch Mischlösungen mit gleichzeitigem Einsatz analoger und digitaler Technik sind möglich.

Fig. 2 zeigt eine Verwendung des Einseitenbandmodulators in einem Hochleistungs-Rundfunksender, wobei aus Übersichtlichkeitsgründen nur die für den Anschluß des Einseitenbandmodulators wesentlichen Teile dargestellt sind.

Mit 20 ist ein Analog-Digital-Wandler bezeichnet, der mit der Taktfrequenz $f_T$ von 100 kHz getaktet ist. Über den Eingang 2 ist dem Analog-Digital-Wandler 20 das NF-Signal N zugeführt, ausgangsseitig ist er mit dem Eingang eines digital aufgebauten Einseitenbandmodulators 1, entsprechend Fig. 1, verbunden, dem das Eingangssignal digital zugeführt wird. An den Ausgängen des Hilberttransformators 5 steht alle 10 µs ein neues Wertepaar zur Verfügung. Da sämtliche Berechnungen innerhalb einer Abtastperiode von 10 µs mit einer Genauigkeit von 12 Bit durchgeführt werden müssen, sind als digitale Bausteine Signalprozessoren verwendet.

Bei der Ausführung eines Hochleistungs-Rundfunksenders gemäß Fig. 3 ist der Einseitenbandmodulator 1 in analoger Schaltungstechnik ausgeführt. Das Eingangssignal N und auch die Ausgangssignale des Einseitenbandmodulators 1 sind analoge Spannungen. Die Digitalisierung für den als Schaltverstärker mit Puls-Stufenmodulation ausgeführten Digital-Analog-Wandler 21 erfolgt hinter dem Einseitenbandmodulator 1 mittels eines Analog-Digital-Wandlers 20.

Das Modulator-Amplitudensignal Z kann statt auf die Anode 23 der HF-Endstufenröhre auch auf ein weiteres Gitter, z. B. auf das Schirmgitter, der Röhre gegeben werden. Das Modulator-Phasensignal 19 kann anstelle mit dem Steuergitter der HF-Endstufenröhre 26 auch mit deren Kathode in Steuerverbindung stehen. Das Bandpaßfilter kann anstelle im Einseitenbandmodulator 1 auch in den Frequenzumsetzer 25 integriert sein. Schliesslich kann der Dividierer 17 im Einseitenbandmodulator 1 fehlen, wobei das für die Phasenmodulation verwendete Abtastsignal einen Amplitudenanteil aufweist.

**Patentansprüche**

1. Einseitenbandmodulationsverfahren,
a) bei dem von einem modulierenden Eingangssignal (N) m um 360°/m phasenverschobene Komponentensignale (x, y) abgeleitet werden, wobei $m \geqq 2$ und ganzzahlig ist, dadurch gekennzeichnet,
b) daß die um 360°/m phasenverschobenen Komponentensignale (x, y) vektoriell zu einem Summenvektor addiert werden und daß anschließend der Betrag des Summenvektors gebildet wird, der ein Modulator-Amplitudensignal (Z) darstellt, und
c) daß alle m um 360°/m phasenverschobenen Komponentensignale mit einer Taktfrequenz ($f_T$), die ein ganzzahliges Vielfaches einer Trägerfrequenz ($f_1$) ist, zyklisch abgetastet werden, wodurch ein Abtastsignal (16') gewonnen wird, das für eine Phasenmodulation verwendbar ist.

2. Einseitenbandmodulationsverfahren nach Anspruch 1, dadurch gekennzeichnet,
a) daß das Abtastsignal (16') durch das Modulator-Amplitudensignal (Z) dividiert und ein Quotientensignal gewonnen wird,
b) insbesondere, daß das Quotientensignal einer Bandpaßfilterung unterzogen wird und danach als zur Phasenmodulation verwendbares Modulator-Phasensignal (19) verfügbar ist.

3. Einseitenbandmodulationsverfahren nach Anspruch 1 oder 2, dadurch gekennzeichnet,
a) daß dem modulierenden Eingangssignal (N) oder
b) mindestens einem der relativ zueinander um 360°/m phasenverschobenen Komponentensignale (x, y) ein konstantes Restträgersignal ($R_1$, $R_2$, $R_3$) zugefügt wird.

4. Einseitenbandmodulationsverfahren nach einem der Ansprüche 1 bis 3, dadurch gekennzeichnet, daß m = 2 und die Taktfrequenz ($f_T$) gleich einer 4fachen Trägerfrequenz ($\omega$) ist.

5. Einseitenbandmodulationsverfahren nach einem der Ansprüche 1 bis 4, dadurch gekennzeichnet, daß das modulierende Eingangssignal (N) mit einem Vielfachen der Trägerfrequenz ($f_1$) abgetastet wird.

6. Einseitenbandmodulator
a) mit einem Phasentrenner (5), der ein modulierendes Eingangssignal (N) in mehrere Komponentensignale (x, y) aufspaltet, die eine feste Phasenbeziehung (360°/m) zueinander haben, wobei $m \geqq 2$ und ganzzahlig ist, dadurch gekennzeichnet,
b) daß ein Amplitudenrechner (8) vorgesehen ist, der in Abhängigkeit von den Komponentensignalen (x, y) ausgangsseitig ein Modulator-Amplitudensignal (Z) erzeugt und
c) daß ein zyklischer Schalter (16) vorgesehen ist, der eine Taktfrequenz ($f_T$) aufweist, die ein ganzzahliges Vielfaches einer Trägerfrequenz ($f_1$) ist, welcher Schalter ausgangsseitig mit den Ausgängen (x, y) des Phasentrenners (5) in Wirkverbindung steht und an dem ausgangsseitig ein Abtastsignal (16') abgreifbar ist, das für eine Phasenmodulation verwendbar ist.

7. Einseitenbandmodulator nach Anspruch 6, dadurch gekennzeichnet,
a) daß dem zyklischen Schalter (16) ein Dividierer (18) nachgeordnet ist, der das Abtastsignal (16') durch das Modulator-Amplitudensignal (Z) dividiert und ein Quotientensignal erzeugt, das für eine Phasenmodulation verwendbar ist,
b) insbesondere, daß ein Bandpaßfilter (18) vorgesehen ist, das eingangsseitig mit dem Ausgang des zyklischen Schalters (16) in Wirkverbindung steht und an dem ausgangsseitig ein Modulator-Phasensignal (19) abgreifbar ist.

8. Einseitenbandmodulator nach einem der Ansprüche 6 oder 7, dadurch gekennzeichnet,
a) daß der Phasentrenner ein Hilberttransformator (5) ist und
b) daß die Taktfrequenz ($f_T$) des zyklischen Schalters (16) gleich der 4fachen Trägerfrequenz ($f_1$) ist.

9. Einseitenbandmodulator nach einem der Ansprüche 6 bis 8, dadurch gekennzeichnet, daß der Phasentrenner (5)
a) entweder eingangsseitig über ein Addierglied (4) einerseits mit dem modulierenden Eingangssignal (N) und andererseits mit einem Restträgersignal ($R_1$) in Wirkverbindung steht oder
b) ausgangsseitig über mindestens ein Summierglied (6, 7) für mindestens ein Komponentensignal (x, y) mit dem Amplitudenrechner (8) in Wirkverbindung steht, wobei diesem Summierglied (6, 7) eingangsseitig ein Restträgersignal ($R_2$, $R_3$) und ein Komponentensignal (x, y) zugeführt sind.

10. Rundfunksender mit einem Einseitenbandmodulator (1) nach einem der Ansprüche 6 bis 9, dadurch gekennzeichnet,
a) daß der Einseitenbandmodulator (1) digital aufgebaut ist,
b) daß der Einseitenbandmodulator über einen Analog-Digital-Wandler (20) mit dem modulierenden Eingangssignal (N) in Wirkverbindung steht, wobei der Analog-Digital-Wandler (20) mit einem Vielfachen der Trägerfrequenz ($f_1$) getaktet ist,

c) daß das Modulator-Amplitudensignal (Z) des Einseitenbandmodulators über einen Digital-Analog-Wandler (21) und

d) ein nachgeschaltetes Hochfrequenz-Filter (22)

e) mit einer Endstufenröhre (26), insbesondere mit der Anode der Endstufenröhre des Rundfunksenders in Wirkverbindung steht,

f) daß das zur Phasenmodulation verwendbare Ausgangssignal oder das Modulator-Phasensignal (19) des Einseitenbandmodulators (1) gegebenenfalls über einen Frequenzumsetzer (25) mit einem Steuergitter der Endstufenröhre (26) in Wirkverbindung steht,

g) insbesondere, daß der Digital-Analog-Wandler (21) ein Schaltverstärker mit mehreren zu- und abschaltbaren Schaltstufen ist.

11. Rundfunksender mit einem Einseitenbandmodulator (1) nach einem der Ansprüche 6 bis 9, dadurch gekennzeichnet,

a) daß das Modulator-Amplitudensignal (Z) des Einseitenbandmodulators (1) über einen Analog-Digital-Wandler (20),

b) ferner über einen diesem nachgeordneten Digital-Analog-Wandler (21) und

c) über ein nachgeschaltetes HF-Filter (22)

d) mit einer Endstufenröhre (26), insbesondere mit der Anode der Endstufenröhre des Rundfunksenders in Wirkverbindung steht,

e) daß das zur Phasenmodulation verwendbare Ausgangssignal oder das Modulator-Phasensignal (19) des Einseitenbandmodulators (1) gegebenenfalls über einen Frequenzumsetzer (25) mit einem Steuergitter der Endstufenröhre (26) in Wirkverbindung steht,

f) insbesondere, daß der Digital-Analog-Wandler (21) ein Schaltverstärker mit mehreren zu- und abschaltbaren Schaltstufen ist.

## Claims

1. Single-sideband modulation method,

a) in which component signals (x, y) phase-shifted by 360°/m are derived from a modulating input signal (N) m, where $l - m = l/2$ and an integral number, characterised in that

b) the component signals (x, y) phase-shifted by 360°/m are vectorially added to form a sum vector and that subsequently the value of the sum vector is formed which represents a modulator amplitude signal (Z), and that

c) all m component signals phase-shifted by 360°/m are cyclically sampled with a clock frequency $(f_T)$ which is an integral multiple of a carrier frequency $(f_1)$, by which means a sampling signal (16') is obtained which can be used for phase modulation.

2. Single-sideband modulation method according to claim 1, characterised in that

a) the sampling signal (16') is divided by the modulator amplitude signal (Z) and a quotient signal is obtained, and particularly that

b) the quotient signal is subjected to band-pass filtering and is subsequently available as a modulator phase signal (19) which can be used for phase modulation.

3. Single-sideband modulation method according to claim 1 or 2, characterised in that a constant residual carrier signal $(R_1, R_2, R_3)$ is added

a) to the modulating input signal (N), or

b) to at least one of the component signals (x, y) phase-shifted by 360°/m with respect to each other.

4. Single-sideband modulation method according to one of claims 1 to 3, characterised in that m = 2 and the clock frequency $(f_T)$ is equal to 4 times the carrier frequency $(\omega)$.

5. Single-sideband modulation method according to one of claims 1 to 4, characterised in that the modulating input signal (N) is sampled with a multiple of the carrier frequency $(f_1)$.

6. Single-sideband modulator

a) including a phase separator (5) which splits a modulating input signal (N) into several component signals (x, y) having a fixed phase relationship (360°/m) with respect to each other, where m = 2 and an integral number, characterised in that

b) an amplitude computer (8) is provided which generates at its output a modulator amplitude signal (Z) as a function of the component signals (x, y), and that

c) a cyclic switch (16) is provided which has a clock frequency $(f_T)$ which is an integral multiple of a carrier frequency $(f_1)$, the output of which switch is effectively connected to the outputs (x, y) of the phase separator (5) and at the output of which a sampling signal (16') can be picked off which can be used for a phase modulation.

7. Single-sideband modulator according to claim 6, characterised in that

a) the cyclic switch (16) ist followed by a divider (18) which divides the sampling signal (16') by the modulator amplitude signal (Z) and generates a quotient signal which can be used for a phase modulation, and particularly that

b) a band-pass filter (18) is provided the input of which is effectively connected to the output of the cyclic switch (16) and at the output of which a modulator phase signal (19) can be picked off.

8. Single-sideband modulator according to one of claims 6 or 7, characterised in that

a) the phase separator is a Hilbert transformer (5), and that

b) the clock frequency $(f_T)$ of the cyclic switch (16) is equal to 4 times the carrier frequency $(f_1)$.

9. Single-sideband modulator according to one of claims 6 to 8, characterised in that the phase separator (5)

a) is either effectively connected at its input via an adder (4), on the one hand, to the modulating input signal (N) and, on the other hand, to a residual-carrier signal $(R_1)$ or

b) is effectively connected at its output via at least one adder (6, 7) for at least one component signal (x, y) to the amplitude computer (8), the input of this adder (6, 7) being supplied with a residual-carrier signal $(R_2, R_3)$ and one component signal (x, y).

10. Broadcast transmitter including a single-sideband modulator (1) according to one of claims 6 to 9, characterised in that

a) the single-sideband modulator (1) is of digital construction,

b) that the single-sideband modulator is effectively connected via an analog/digital converter (20) to the modulating input signal (N), the analog/digital converter (20) being clocked with a multiple of the carrier frequency $(f_1)$,

c) that the modulator amplitude signal (Z) of the single-sideband modulator is effectively connected via a digital/analog converter (21) and

d) a subsequent radio-frequency filter (22)

e) to an output stage tube (26), particularly to the anode of the output stage tube of the broadcast transmitter

f) that the output signal used for phase modulation or the modulator phase signal (19) of the single-sideband modulator (1) is effectively connected, if necessary, via a frequency converter (25) to a control grid of the output stage tube (26),

g) particularly that the digital/analog converter (21) is a switching amplifier having several switching stages which can be connected or disconnected.

11. Broadcast transmitter including a single-sideband modulator (1) according to one of claims 6 to 9, characterised in that

a) the modulator amplitude signal (Z) of the single-sideband modulator (1) is effectively connectd via an analog/digital converter (20),

b) furthermore via a digital/analog converter (21) following the former converter, and

c) via a subsequent RF filter (22)

d) to an output stage tube (26), particularly to the anode of the output stage tube of the broadcast transmitter,

e) that the output signal which can be used for phase modulation or the modulator phase signal (19) of the single-sideband modulator (1) is possibly effectively connected to a control grid of the output stage tube (26) via a frequency converter (25),

f) particularly that the digital-analog converter (21) is a switching amplifier having several switching stages which can be connected and disconnected.

**Revendications**

1. Procédé de modulation à bande latérale unique,

a) dans lequel m signaux de composantes (x, y) déphasés de 360°/m sont dérivés d'un signal d'entrée de modulation (N), où m ≧ 2 et est un nombre entier, caractérisé en ce

b) que les signaux de composantes (x, y) déphasées de 360°/m subissent une addition vectorielle pour former un vecteur de somme dont est formée ensuite la valeur absolue qui représente un signal d'amplitude de modulateur (Z), et

c) que les m signaux de composantes déphasées de 360°/m d'une fréquence d'horloge $(f_T)$, qui est un multiple entier d'une fréquence de porteuse $(f_1)$, sont tous échantillonnés de manière cyclique de sorte que l'on obtient un signal d'échantillonnage (16') qui peut être utilisé pour une modulation de phase.

2. Procédé de modulation à bande latérale unique suivant la revendication 1, caractérisé en ce

a) que le signal d'échantillonnage (16') est divisé par le signal d'amplitude de modulateur (Z) en fournissant un signal de quotient,

b) qu'en particulier, le signal de quotient est soumis à un filtrage passe-bande et est ensuite disponible en tant que signal de phase de modulateur (19) utilisable pour la modulation de phase.

3. Procédé de modulation à bande latérale unique suivant la revendication 1 ou 2, caractérisé en ce

a) qu'au signal d'entrée de modulation (N), ou

b) au moins à un des signaux de composantes (x, y) déphasées l'une de l'autre de 360°/m est ajouté un signal de porteuse résiduelle $(R_1, R_2, R_3)$ constant.

4. Procédé de modulation à bande latérale unique suivant l'une quelconque des revendications 1 à 3, caractérisé en ce que m = 2 et la fréquence d'horloge $(f_T)$ est égale au quadruple de la fréquence de porteuse (ω).

5. Procédé de modulation à bande latérale unique suivant l'une quelconque des revendications 1 à 4, caractérisé en ce que le signal d'entrée de modulation (N) est échantillonné à un multiple de la fréquence de porteuse $(f_1)$.

6. Modulateur à bande latérale unique

a) comportant un séparateur de phases (5) qui divise un signal d'entrée de modulation (N) en plusieurs signaux de composantes (x, y) qui se trouvent dans une relation de phase fixe (360°/m) l'une par rapport à l'autre, où m ≧ 2 et est un nombre entier, caractérisé en ce

b) qu'un calculateur d'amplitude (8) est prévu qui, en fonction des signaux de composantes (x, y), produit à sa sortie un signal d'amplitude de modulateur (Z), et

c) qu'un commutateur cyclique (16) est prévu qui présente une fréquence d'horloge $(f_T)$ qui est un multiple entier d'une fréquence de porteuse $(f_1)$, ce commutateur étant en connexion active par sa sortie avec les sorties (x, y) du séparateur de phases (5) et pouvant fournir à sa sortie un signal d'échantillonnage (16') qui peut être utilisé pour une modulation de phase.

7. Modulateur à bande latérale unique suivant la revendication 6, caractérisé en ce

a) que le commutateur cyclique (16) est suivi d'un diviseur (18), qui divise le signal d'échantillonnage (16') par le signal d'amplitude de modulateur (Z) et produit un signal de quotient qui peut être utilisé pour une modulation de phase,

b) qu'en particulier, un filtre passe-bande (18) est prévu qui est en connexion active par son entrée avec la sortie du commutateur cyclique (16) et dont un signal de phase de modulateur (19) peut être obtenu à la sortie.

8. Modulateur à bande latérale unique suivant l'une ou l'autre des revendications 6, 7, caractérisé en ce

a) que le séparateur de phases est un transformateur de Hilbert (5), et

b) que la fréquence d'horloge (f_T) du commutateur cyclique (16) est égale au quadruple de la fréquence de porteuse (f_1).

9. Modulateur à bande latérale unique suivant l'une quelconque des revendications 6 à 8, caractérisé en ce que le séparateur de phases (5) est

a) soit en connexion active par son entrée, par l'intermédiaire d'un élément additionneur (4), d'une part, au signal d'entrée de modulation (N) et, d'autre part, à un signal de porteuse résiduelle (R_1), soit

b) en connexion active par sa sortie, par l'intermédiaire d'au moins un élément sommateur (6, 7) pour au moins un signal de composante (x, y), avec le calculateur d'amplitude (8), cet élément sommateur (6, 7) recevant sur son entrée un signal de porteuse résiduelle (R_2, R_3) et un signal de composante (x, y).

10. Emetteur de radiodiffusion équipé d'un modulateur à bande latérale unique (1) suivant l'une quelconque des revendications 6 à 9, caractérisé en ce

a) que le modulateur à bande latérale unique (1) est de structure numérique,

b) que le modulateur à bande latérale unique est en connexion active, par l'intermédiaire d'un convertisseur analogique-numérique (20), avec le signal d'entrée de modulation (N), le convertisseur analogique-numérique (20) étant rythmé à un multiple de la fréquence de porteuse (f_1),

c) que le signal d'amplitude de modulateur (Z) du modulateur à bande latérale unique est en connexion active, par l'intermédiaire d'un convertisseur numérique-analogique (21), et

d) d'un filtre à haute fréquence (22) placé en aval,

e) avec un tube d'étage final (26), en particulier avec l'anode du tube d'étage final de l'émetteur de radiodiffusion,

f) que le signal de sortie utilisable pour la modulation de phase ou le signal de phase de modulateur (19) du modulateur à bande latérale unique (1) est en connexion active, le cas échéant par l'intermédiaire d'un convertisseur de fréquence (25), avec une grille de commande du tube d'étage final (26),

g) qu'en particulier, le convertisseur numérique-analogique (21) est un amplificateur de commutation comportant plusieurs étages de commutation enclenchables et déclenchables.

11. Emetteur de radiodiffusion équipé d'un modulateur à bande latérale unique (1) suivant l'une quelconque des revendications 6 à 9, caractérisé en ce

a) que le signal d'amplitude de modulateur (Z) du modulateur à bande latérale unique (1) est en connexion active, par l'intermédiaire d'un convertisseur analogique-numérique (20),

b) outre par l'intermédiaire d'un convertisseur numérique-analogique (21) placé en aval, et

c) par l'intermédiaire d'un filtre HF (22) placé en aval,

d) avec un tube d'étage final (26), en particulier avec l'anode du tube d'étage final de l'émetteur de radiodiffusion,

e) que le signal de sortie ou le signal de phase de modulateur (19) du modulateur à bande latérale unique (1) utilisable pour la modulation de phase est en connexion active, le cas échéant par l'intermédiaire d'un convertisseur de fréquence (25), avec une grille de commande du tube d'étage final (26),

f) qu'en particulier, le convertisseur numérique-analogique (21) est un amplificateur de commutation comportant plusieurs étages de commutation enclenchables et déclenchables.

EP 0193655 B1

FIG. 1

FIG. 2

FIG. 3

9